# FASCICULE DE BREVET EUROPEEN

(11) **EP 0 828 350 B1**
(45) Date de publication et mention de la délivrance du brevet: **24.11.1999**
(21) Numéro de dépôt: 97410100.8
(22) Date de dépôt: 09.09.1997
(51) Int. Cl.: H03L 7/089

(54) **Boucle à verrouillage de phase avec dispositif de limitation de courant de pompe de charge**
Phasenregelkreis mit einer Vorrichtung zur Begrenzung des Stroms einer Ladungspumpe
Phase locked loop with a charge pump current limiting arrangement

(30) Priorité: 09.09.1996 FR 9611221
(43) Date de publication de la demande: 11.03.1998
(73) Titulaire: STMicroelectronics S.A., 94250 Gentilly (FR)
(72) Inventeur: Lebouleux, Nicolas, 38000 Grenoble (FR); Berger, Philippe, 38920 Crolles (FR); Cirot, Eric, 38600 Fontaine (FR)
(74) Mandataire: de Beaumont, Michel

(56) Documents cités:
- EP-A- 0 218 508
- GB-A- 2 257 587
- US-A- 4 987 387
- US-A- 5 497 127

## Description

L'invention concerne une boucle à verrouillage de phase comprenant un dispositif de limitation de courant de pompe de charge. Une telle boucle à verrouillage de phase est décrite dans le document de brevet US-A-5 497 127. Elle trouve une application par exemple dans le domaine du traitement de signaux de synchronisation relatifs à l'affichage sur un écran.

Pour contrôler l'affichage de données et d'images sur un moniteur ou un écran de télévision et, plus particulièrement, pour contrôler le balayage d'un faisceau d'électrons sur un écran, on utilise des signaux de synchronisation. Ces signaux de synchronisation s'ajoutent au signal utile, c'est-à-dire au signal représentatif des données ou images à afficher. Ils contiennent des informations temporelles permettant de repérer le début des lignes (il s'agit alors de la synchronisation horizontale) et le début des trames (il s'agit alors de la synchronisation verticale). En fonction de ces signaux, on commande des déflecteurs qui orientent le faisceau d'électrons balayant l'écran.

En pratique, les signaux de synchronisation sont des signaux logiques impulsionnels définis principalement par la polarité, positive ou négative, de leurs impulsions, la fréquence de récurrence de ces impulsions et leur durée.

La prise en compte des signaux de synchronisation se fait généralement d'une part par le biais de boucles à contrôle automatique de gain, pour ce qui concerne la synchronisation verticale et, d'autre part, par le biais de boucles à verrouillage de phase, pour ce qui concerne la synchronisation horizontale.

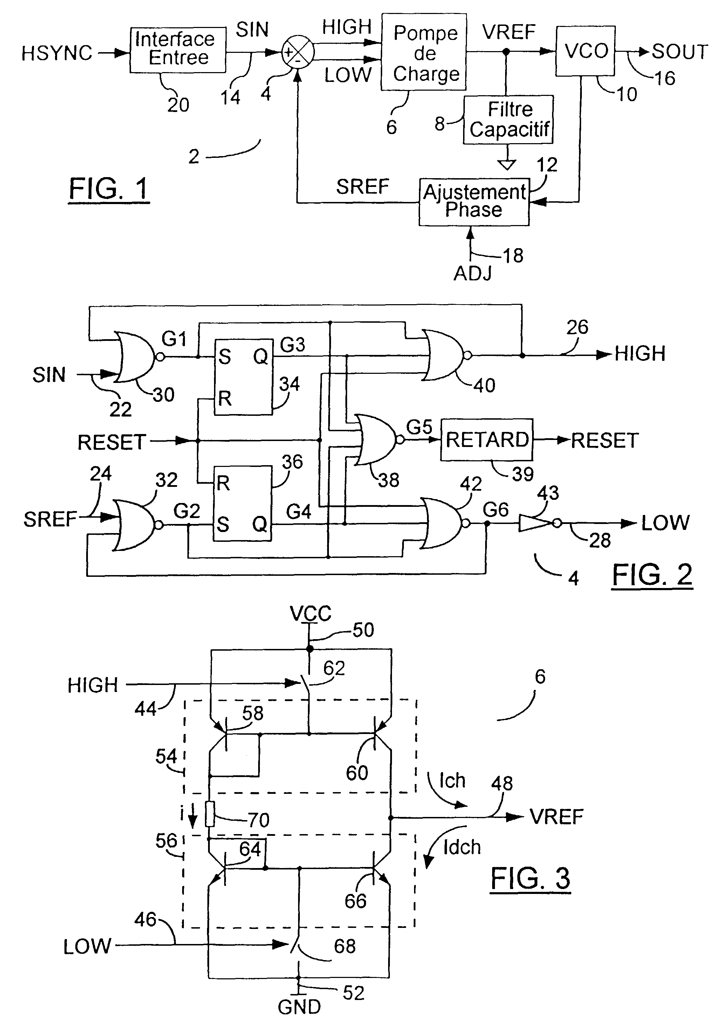

La figure 1 illustre une boucle à verrouillage de phase 2 de type connu, mettant en oeuvre un comparateur de type phase/fréquence. Une telle boucle est par exemple mise en oeuvre dans les circuits TDA 9103 et TDA 9105 produits par la société SGS-THOMSON Microelectronics, pour traiter des signaux de synchronisation horizontale. Elle comprend un comparateur 4 de type phase/fréquence, une pompe de charge 6, un filtre capacitif 8, un oscillateur 10 contrôlé en tension (encore appelé VCO), et un dispositif d'ajustement de phase 12.

Le comparateur 4 sert à comparer un signal impulsionnel d'entrée SIN reçu sur une entrée 14, avec un signal impulsionnel de référence SREF fourni par le dispositif d'ajustement de phase 12.

En fonction de la comparaison, le comparateur 4 commande la pompe de charge 6. Cette pompe va charger ou décharger le filtre 8, de sorte que la tension VREF produite par le filtre sera représentative du résultat de la comparaison entre SIN et SREF.

L'oscillateur 10 produit, à partir de la tension VREF, un signal triangulaire de sortie SOUT dont la fréquence est proportionnelle à la tension VREF. Ce signal SOUT est fourni, d'une part, sur une sortie 16 et, d'autre part, au dispositif 12.

Le dispositif 12 produit le signal de référence SREF à partir du signal SOUT et d'un signal SADJ de commande d'ajustement de phase. Le signal ADJ est reçu sur une entrée 18 et est utilisé pour positionner les fronts dans le signal SREF, la fréquence des impulsions dans le signal SREF étant identique à la fréquence de récurrence du signal SOUT.

Une fois que les signaux SIN et SREF sont en phase et de même fréquence, la tension VREF se stabilise. On parle alors de verrouillage de la boucle 2.

Enfin, on notera que le signal SIN est fourni par une interface d'entrée 20 qui permet, typiquement, à partir d'un signal de synchronisation HSYNC reçu, de produire un signal SIN de polarité fixe. Le signal HSYNC pourra être un signal de synchronisation horizontale de polarité quelconque, voire un signal de type composite, auquel cas le signal SIN est obtenu par extraction des impulsions de synchronisation horizontale.

La figure 2 illustre un exemple de comparateur 4, de type phase/fréquence. Le comparateur pourrait être un comparateur de phase simple. L'utilisation d'un comparateur de type phase/fréquence permet d'éviter un verrouillage de la boucle sur une fréquence multiple de la fréquence du signal d'entrée SIN. Un problème est que ce type de comparateur est très sensible à l'absence d'impulsions et à la présence d'impulsions supplémentaires (tels que des impulsions d'égalisation).

Le comparateur comprend une entrée 22 pour recevoir le signal SIN, une entrée 24 pour recevoir le signal SREF, une sortie 26 pour fournir un signal de commande de charge HIGH et une sortie 28 pour fournir un signal de commande de décharge LOW. Une porte logique 30 de type NON_OU à deux entrées reçoit les signaux SIN et HIGH sur ses entrées. Elle produit un signal logique G1. Une porte logique 32 de type NON_OU à deux entrées reçoit sur ses entrées les signaux SREF et un signal logique G6, inverse du signal LOW. Elle produit un signal logique G2.

Une bascule 34 de type RS reçoit le signal G1 sur son entrée d'initialisation S. Elle reçoit un signal RESET sur son entrée de réinitialisation R. Elle produit un signal logique G3 sur sa sortie Q. Une bascule 36 de type RS reçoit le signal G2 sur son entrée d'initialisation. Elle reçoit le signal RESET sur son entrée de réinitialisation. Elle produit un signal logique G4.

Une porte logique 38 de type NON_OU à quatre entrées reçoit les signaux G1, G2, G3 et G4 sur ses entrées et produit un signal logique G5. Le signal G5 est fourni à un circuit à retard 39. Le circuit 39 produit le signal RESET, ce signal étant identique au signal G5 affecté d'un retard.

Une porte logique 40 de type NON_OU à trois entrées reçoit les signaux G1, G3 et RESET sur ses entrées et produit le signal HIGH. Enfin, une porte logique 42 de type NON_OU à trois entrées reçoit les signaux G2, G4, et RESET sur ses entrées et produit le signal G6. Le signal G6 est fourni à un inverseur 43 qui produit le signal LOW.

La figure 3 illustre un exemple de pompe de charge 6.

Elle comprend une entrée 44 pour recevoir le signal de commande HIGH, une entrée 46 pour recevoir le signal de commande LOW, une sortie 48 reliée au filtre 8, une entrée d'alimentation 50 pour recevoir un potentiel positif d'alimentation VCC et une entrée d'alimentation 52 pour recevoir un potentiel de masse GND.

La pompe 6 comprend deux miroirs de courant 54 et 56.

Un premier miroir 54 est formé par deux transistors 58 et 60, par exemple de type PNP. Leurs émetteurs sont reliés à l'entrée 50. Leurs bases sont reliées entre elles et au collecteur du transistor 58. Un interrupteur 62, commandé par le signal HIGH, permet de relier ces bases à l'entrée 50.

Un second miroir 56 est formé par deux transistors 64 et 66, par exemple de type NPN. Leurs émetteurs sont reliés à l'entrée 52. Leurs bases sont reliées entre elles et au collecteur du transistor 64. Un interrupteur 68, commandé par le signal LOW, permet de relier ces bases à l'entrée 52.

Les collecteurs des transistors 58 et 64 sont reliés entre eux par le biais d'une résistance 70. Les collecteurs des transistors 60 et 66 sont reliés à la sortie 48.

Le courant i circulant dans les transistors 58 ou 64 est égal à (VCC - Vbe) / R1, en notant R1 la valeur de la résistance 70 et Vbe la tension base/émetteur de ces transistors. Lorsque l'interrupteur 62 est ouvert, ce courant est recopié dans le transistor 60. On charge alors le filtre 8 avec un courant de charge Ich = i. Lorsque c'est l'interrupteur 68 qui est ouvert, le courant i est recopié dans le transistor 66. On décharge alors le filtre avec un courant de décharge Idch = i.

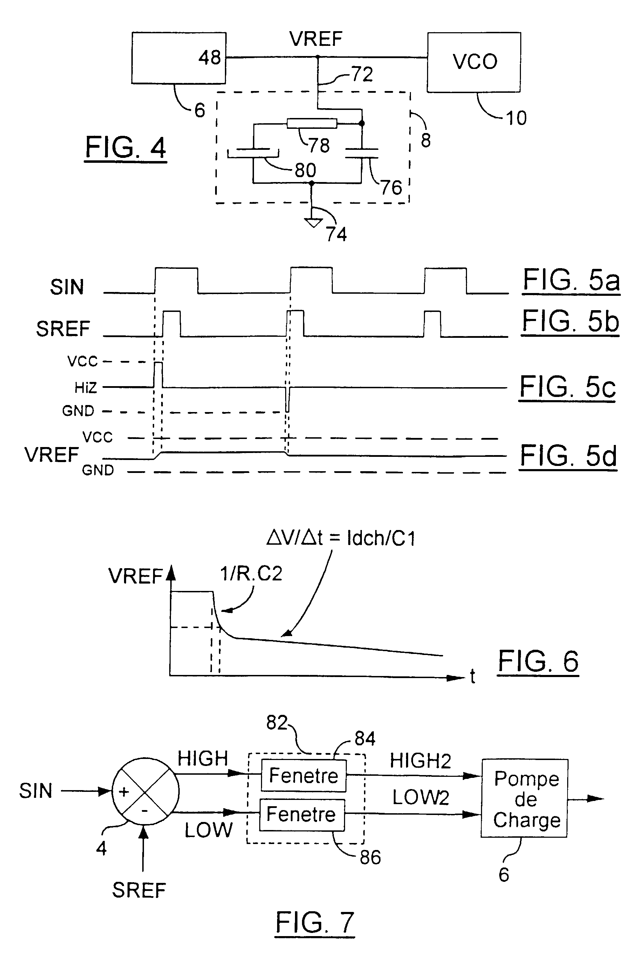

La figure 4 illustre un exemple de filtre 8. C'est un filtre capacitif de type C-R-C qui comprend une première entrée 72, reliée à la sortie 48 de la pompe de charge et à une entrée de l'oscillateur 10, et une seconde entrée 74 recevant le potentiel de masse. La tension VREF produite par le filtre est la différence de potentiel entre les entrées 72 et 74.

Le filtre comprend une première capacité 76, montée entre les entrées 72 et 74. Il comprend également une résistance 78 et une seconde capacité 80 montées en série entre ces mêmes entrées. La capacité 80, de valeur importante (par exemple de 4,7 microfarads ou plus), est utilisée pour conserver la tension VREF. Elle évite une chute (au potentiel GND) et une montée (au potentiel VCC) trop rapides de la tension VREF quand les fronts sont éloignés dans les signaux SIN et SREF. La capacité 76, de valeur faible (par exemple de l'ordre de 10 nanofarads), permet une adaptation rapide de la tension VREF au résultat de la comparaison entre les signaux SIN et SREF, quand les fronts dans ces signaux sont proches.

En pratique, le filtre est réalisé en composants discrets, les autres éléments étant actuellement réalisés le plus souvent sous forme d'un circuit intégré.

En référence aux figures 5a à 5d, on va maintenant décrire brièvement le fonctionnement d'une partie de la boucle et, plus particulièrement, la production de la tension VREF (illustrée sur la figure 5d) en fonction des signaux SIN et SREF (illustrés sur les figures 5a et 5b). La figure 5c illustre la sortie de courant de la pompe 6. On suppose que les signaux SIN et SREF sont de polarité positive. Il y a verrouillage de la boucle quand les fronts montants des signaux SREF et SIN correspondent temporellement. On suppose, par ailleurs, que la fréquence du signal SOUT augmente quand la tension VREF augmente et inversement.

Supposons que la boucle est verrouillée. La sortie de la pompe 6 est en haute impédance. Les signaux HIGH et LOW sont dans un état tel que les interrupteurs 62 et 68 sont fermés, c'est-à-dire passants. Ici , on suppose que les interrupteurs 62 et 68 sont fermés quand les signaux HIGH et LOW sont respectivement à l'état bas et à l'état haut, et qu'ils sont ouverts sinon. Pour réaliser les interrupteurs 62 et 68, on utilisera par exemple des transistors de type MOS, respectivement à canal P et à canal N. La tension VREF est stabilisée à une valeur comprise entre les potentiels VCC et GND. Les signaux G1, G2, G3 et G4 sont à l'état haut.

Si la fréquence des impulsions dans le signal SIN augmente, les fronts montants dans ce signal vont être en avance sur les fronts dans le signal SREF tant que la boucle n'est pas verrouillée sur la nouvelle fréquence.

Si un front montant apparaît dans le signal SIN, le signal G1 passe à l'état bas. En conséquence, le signal G3 descend à l'état bas et le signal HIGH monte à l'état haut. On ouvre alors l'interrupteur 62, ce qui provoque une charge du filtre capacitif. Au front montant suivant dans le signal SREF, le signal G2 passe à l'état bas. Cela entraîne la descente à l'état bas du signal G4. En conséquence, le signal LOW passe à l'état bas et simultanément le signal G5 passe à l'état haut. Ultérieurement, le signal RESET passe à l'état haut. Les signaux G3 et G4 passent donc à l'état haut et on ferme les interrupteurs 62 et 68. La sortie de la pompe passe ainsi en haute impédance jusqu'au front montant suivant dans le signal SIN. L'interrupteur 62 est donc ouvert sur les fronts montants du signal SIN et il est fermé sur les fronts montants du signal SREF qui suivent.

Si la fréquence des impulsions dans le signal SIN diminue, les fronts montants dans ce signal vont être en retard sur les fronts dans le signal SREF tant que la boucle n'est pas verrouillée sur la nouvelle fréquence.

Si un front montant apparaît dans le signal SREF, le signal G2 passe à l'état bas. En conséquence, le signal G4 descend à l'état bas et le signal LOW passe à l'état bas. On ouvre alors l'interrupteur 68, ce qui provoque une décharge du filtre capacitif. Au front montant suivant dans le signal SIN, le signal G1 passe à l'état bas. Cela entraîne la descente à l'état bas du signal G3. En conséquence, le signal HIGH passe à l'état haut et, simultanément, le signal G5 passe à l'état haut. Ultérieurement, le signal RESET passe à l'état haut. Les signaux G3 et G4 passent donc à l'état haut et on ferme les interrupteurs 62 et 68. La sortie de la pompe passe ainsi en haute impédance jusqu'au front montant suivant dans le signal SREF. L'interrupteur 68 est donc ouvert sur les fronts montants du signal SREF et il est fermé sur les fronts montants du signal SIN qui suivent.

Comme on le voit, la tension VREF n'est stable que si la boucle est verrouillée. On retarde le signal RESET, de façon à produire des impulsions dans les signaux de commande LOW et HIGH, même quand la boucle est verrouillée. La durée de ces impulsions sera très courte et ne modifiera donc pas de manière importante la tension VREF. Cela permet de limiter les phénomènes de gigue dans la boucle à verrouillage de phase.

Lorsqu'il y a diminution, voire annulation, de la fréquence des impulsions dans le signal SIN (par exemple suite à un changement de standard d'affichage dans le signal fourni à un moniteur, ou si il y a perte de la synchronisation), le comparateur 4 vient commander l'interrupteur 68 de sorte que l'on décharge le filtre capacitif. Ce cas est illustré sur la figure 6 qui représente la tension VREF. On note R la valeur de la résistance 78, C1 la valeur de la capacité 80 et C2 la valeur de la capacité 76. Dans un premier temps, la capacité 76 se décharge rapidement selon une pente en 1/R.C2. La tension VREF diminue alors rapidement. Une fois la capacité 76 déchargée, la capacité 80 se décharge plus lentement selon une pente en ΔV/Δt = Idch/C1. On va donc, dans un premier temps, assister à une variation importante de la fréquence dans le signal SOUT.

Un problème se pose dans la mesure où, typiquement, le signal SOUT est utilisé pour commander des déflecteurs horizontaux (équivalents à des inductances), par le biais d'un transistor de puissance. Typiquement, la tension sur le collecteur de ce transistor est proportionnelle à une tension d'alimentation variable (notée E par la suite), à la période du signal de synchronisation horizontale et à l'inverse de la racine carrée de l'inductance équivalente des déflecteurs. Dans le domaine des moniteurs, par exemple, la fréquence horizontale est comprise entre 15 et 150 kilohertz, la tension E de l'ordre de la centaine de volts et l'inductance équivalente est de l'ordre du millihenry. La tension crête sur le collecteur du transistor est ainsi de l'ordre du kilovolt.

En pratique, plus la fréquence est importante, plus la tension E est importante, ce qui permet de commander plus rapidement le balayage. Un problème est que la régulation de l'alimentation E est lente, ce qui peut induire une tension crête transitoire de plusieurs kilovolts sur le collecteur du transistor de puissance, quand la fréquence de synchronisation horizontale varie. Si les variations sont trop brusques, on peut aboutir à la destruction de ce transistor, ce qui rend inopérant l'affichage.

Une solution est de modifier le filtre de telle sorte que sa courbe de réponse soit moins abrupte quand la fréquence varie, par exemple en augmentant la valeur de la capacité 76. On augmente alors le temps de réaction de la pompe, ce qui induit un risque de gigue entre les signaux d'entrée et de référence. On peut aussi diminuer le courant de charge et de décharge du filtre. Un problème est que l'on diminue alors la stabilité de la boucle et qu'on augmente le temps de réaction de la pompe.

Un but de l'invention est de proposer une boucle à verrouillage de phase améliorée, dans laquelle les variations de fréquence du signal de sortie sont limitées, tout en étant facilement intégrable en termes de composants et de dimension. Pour ce faire, on propose de limiter temporellement la charge et la décharge du filtre, en intervenant sur les signaux de commande des interrupteurs de la pompe. De la sorte, on limite les variations de la tension VREF, tension à laquelle est proportionnelle la fréquence du signal de sortie SOUT produit par l'oscillateur 10. Ce but est atteint à l'aide d'une boucle à verrouillage de phase selon la revendication 1.

Ainsi, l'invention propose une boucle à verrouillage de phase comprenant un comparateur, une pompe de charge, un filtre capacitif, un oscillateur contrôlé en tension et un dispositif d'ajustement de phase. Le comparateur compare les phases d'un signal impulsionnel d'entrée et d'un signal impulsionnel de référence fourni par le dispositif d'ajustement de phase, et produit des signaux de commande de charge et de décharge. La pompe de charge est apte à charger ou décharger le filtre capacitif en fonction des signaux de commande de charge et de décharge, le filtre étant chargé ou déchargé quand ces signaux sont dans un premier état et isolé de la pompe de charge quand ils sont dans un deuxième état. La boucle comprend un dispositif de limitation du courant de charge et de décharge du filtre capacitif, ce dispositif comprenant des circuits de fenêtrage pour limiter la durée pendant laquelle les signaux de commande de charge et de décharge sont dans leur premier état. Le dispositif de limitation comprend un circuit de détection de verrouillage de la boucle et la pompe de charge comprend des moyens pour limiter la valeur du courant de charge ou de décharge du filtre. Le circuit de détection de verrouillage produit un signal de détection de verrouillage représentatif du fait que la boucle est ou n'est pas verrouillée, le signal de détection étant fourni aux circuits de fenêtrage et à la pompe de charge, de manière à limiter la durée pendant laquelle les signaux de commande de charge et de décharge sont dans leur premier état quand la boucle est verrouillée, et à limiter la valeur du courant de charge ou de décharge quand la boucle n'est pas verrouillée.

D'autres avantages et particularités apparaîtront à la lecture de la description qui suit d'exemples de réalisation de l'invention, à lire conjointement aux dessins annexés dans lesquels :
- la figure 1 illustre une boucle à verrouillage de phase selon l'état de la technique,
- la figure 2 illustre un comparateur de type phase/fréquence selon l'état de la technique,
- la figure 3 illustre une pompe de charge selon l'état de la technique,
- la figure 4 illustre un filtre capacitif selon l'état de la technique,
- les figure 5a à 5d illustrent des chronogrammes de signaux mis en oeuvre dans les circuits illustrés sur les figures 1 à 4,
- la figure 6 illustre un chronogramme de la tension produite par le filtre capacitif lors d'une variation de la fréquence de signaux reçus par la boucle,
- la figure 7 illustre schématiquement un circuit de limitation de courant de pompe de charge selon l'état de la technique,
- la figure 8 illustre un circuit de fenêtrage mis en oeuvre dans le circuit de limitation illustré sur la figure 7,
- la figure 9 illustre un circuit de limitation de courant de pompe de charge selon l'invention,
- la figure 10 illustre un circuit de détection de verrouillage mis en oeuvre dans le circuit de limitation illustré sur la figure 9,
- la figure 11 illustre un circuit de fenêtrage mis en oeuvre dans le circuit de limitation illustré sur la figure 9,
- la figure 12 illustre une pompe de charge modifiée,
- les figures 13a à 13c illustrent des chronogrammes de signaux illustrant la modification de la tension produite par un filtre capacitif de boucle selon l'état de la technique et selon l'invention.

On supposera, dans la description qui suit d'un dispositif de limitation de la variation de la tension produite par le filtre, que les signaux de commande LOW et HIGH qui pilotent la pompe de charge commandent l'ouverture des interrupteurs de cette pompe quand ils sont respectivement à l'état bas et à l'état haut, et qu'ils commandent la fermeture de ces interrupteurs quand ils sont dans les états inverses.

Le dispositif 82, illustré sur la figure 7, permet de limiter le temps maximal pendant lequel les signaux LOW et HIGH sont respectivement à l'état bas et à l'état haut. Il est disposé entre le comparateur 4 de la boucle et la pompe de charge 6.

Le dispositif 82 reçoit les signaux HIGH et LOW du comparateur placé en amont. Il produit deux signaux de commande dérivés HIGH2 et LOW2 qui sont fournis à la pompe de charge placée en aval. En référence à la figure 3, les signaux HIGH2 et LOW2 seront fournis aux entrées 44 et 46 de la pompe.

Le dispositif 82 comprend deux circuits de fenêtrage 84 et 86 qui reçoivent respectivement les signaux HIGH et LOW, et qui produisent respectivement les signaux HIGH2 et LOW2.

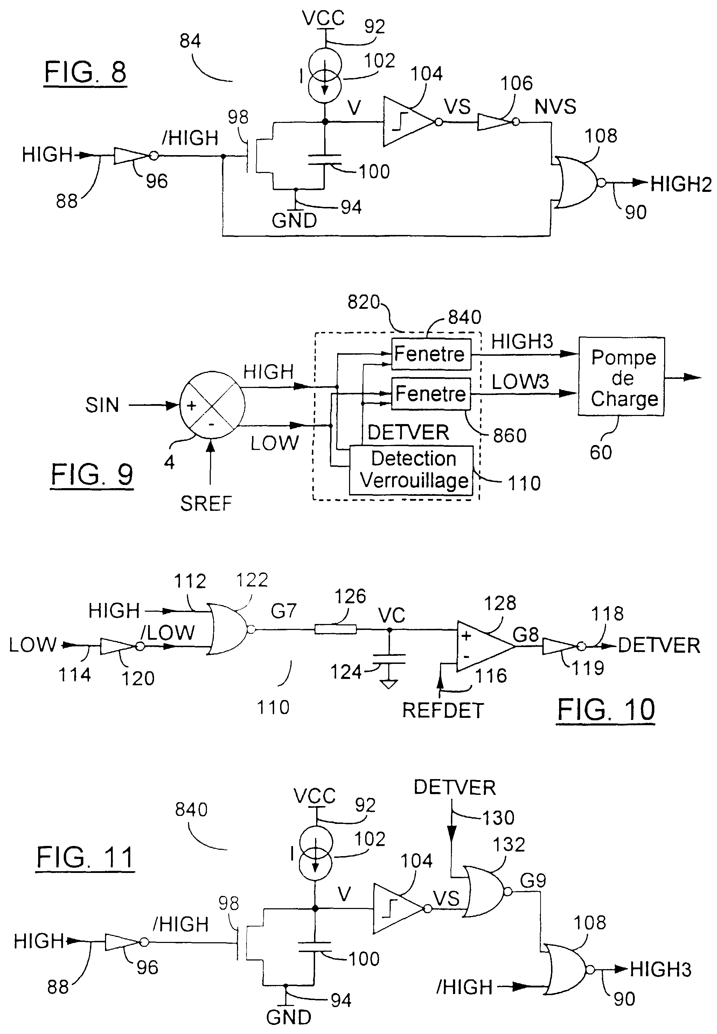

La figure 8 illustre un exemple de réalisation du circuit 84. Le circuit 86 sera analogue dans sa constitution.

Le circuit 84 comprend une entrée 88 pour recevoir le signal HIGH, une sortie 90 pour fournir le signal HIGH2, une première entrée d'alimentation 92 pour recevoir un potentiel d'alimentation VCC et une deuxième entrée d'alimentation 94 pour recevoir un potentiel de référence (ou masse) GND. Un inverseur 96, ayant une entrée et une sortie, reçoit le signal HIGH sur son entrée et produit un signal /HIGH sur sa sortie. Le signal /HIGH est le signal inverse du signal HIGH.

Un transistor 98, de type MOS à canal N, reçoit le signal /HIGH sur sa grille de commande. Ce transistor est utilisé comme interrupteur. Il est passant quand le signal /HIGH est dans un premier état logique. Il est bloqué quand le signal /HIGH est dans un deuxième état logique. Dans l'exemple, le transistor 98 étant à canal N, le premier état correspond à l'état haut et le deuxième état correspond à l'état bas.

La source du transistor 98 est reliée à l'entrée 94 et son drain est relié à une première borne d'une capacité 100. La capacité 100 a une deuxième borne qui est reliée à l'entrée 94. On note C la valeur de la capacité 100.

Une source de courant 102 est montée entre la première borne de la capacité 100 et l'entrée 92. Elle fournit un courant I. On note V la tension présente aux bornes de la capacité 100.

Un comparateur a une entrée reliée à la première borne de la capacité 100. Dans l'exemple illustré sur la figure 8, le comparateur est un inverseur 104. Il produit sur une sortie un signal logique VS. Le signal VS est tel qu'il est dans un premier état quand la tension V est inférieure à un seuil Vseuil et qu'il est dans un deuxième état quand la tension V est au-dessus de ce seuil. Le premier état correspond dans l'exemple à l'état haut et le deuxième état correspond à l'état bas. Un inverseur 106 reçoit sur une entrée le signal VS. Il produit un signal logique NVS sur une sortie, ce signal étant l'inverse du signal VS. Une porte logique 108 de type NON_OU à deux entrées et une sortie reçoit les signaux /HIGH et NVS sur ses entrées. Elle produit le signal HIGH2 sur sa sortie.

Lorsque le signal HIGH est à l'état bas, le signal /HIGH est à l'état haut. On court-circuite alors les bornes de la capacité 100 par le biais du transistor 98. La capacité 100 va se décharger, si elle était chargée. Une fois déchargée, les signaux VS et HIGH2 sont à l'état bas.

Lorsque le signal HIGH passe à l'état haut, le signal /HIGH change d'état et le transistor 98 se bloque. La capacité 100 se charge alors à courant constant et la tension V augmente en fonction du temps. On a V (t) = I . t / C, avec t = 0 au début de la montée à l'état haut du signal HIGH. Parallèlement, le signal HIGH2 passe à l'état haut, reproduisant le signal HIGH.

Soit Tseuil le délai tel que V(Tseuil) = Vseuil.

Si le signal HIGH est maintenu à l'état haut pendant une durée T telle que T est inférieure à Tseuil, alors le signal VS est toujours à l'état bas quand le signal HIGH revient à l'état bas. Le signal HIGH2 repasse alors à l'état bas. Parallèlement, on décharge la capacité 100 par le biais du transistor 98.

Si le signal HIGH est maintenu à l'état haut pendant une durée T telle que T est supérieure à Tseuil, alors le signal VS passe à l'état haut une fois le seuil Vseuil atteint. Le signal HIGH2 repasse alors à l'état bas. On limite donc le temps de charge du filtre alimenté par la pompe de charge située en aval du dispositif 82.

Ultérieurement, quand le signal HIGH repasse à l'état bas, on décharge la capacité 100 par le biais du transistor 98. Le signal VS repasse à l'état bas une fois le seuil Vseuil atteint.

Les figures 9 à 12 illustrent un mode de réalisation d'un dispositif 820 de limitation selon l'invention, dans lequel on tient compte du fait que la boucle est verrouillée ou non.

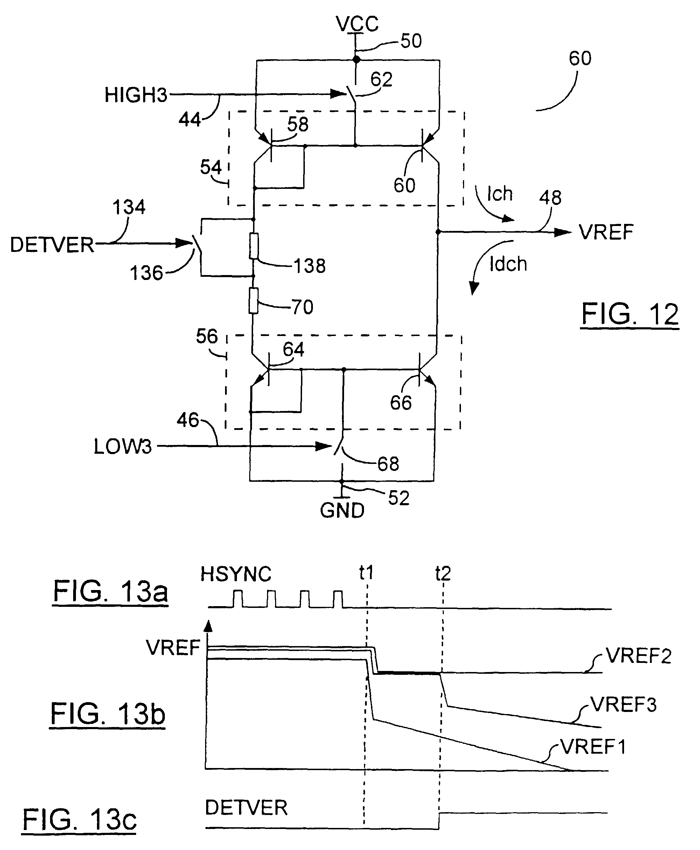

Le dispositif 820 illustré sur la figure 9 permet, de manière analogue au circuit 82 illustré sur la figure 7, de limiter le temps maximal pendant lequel les signaux LOW et HIGH sont respectivement à l'état bas et à l'état haut. Il est disposé entre le comparateur 4 de la boucle et une pompe de charge modifiée 60 (illustrée sur la figure 12). Il comprend deux circuits de fenêtrage 840 et 860 qui reçoivent respectivement les signaux HIGH et LOW et qui produisent respectivement des signaux HIGH3 et LOW3. Il comprend également un circuit de détection de verrouillage 110. Ce circuit 110 fournit un signal logique DETVER aux circuits 840 et 860, ce signal étant représentatif du fait que la boucle est verrouillée ou non.

Le circuit 110, illustré sur la figure 10, comprend deux entrées 112 et 114 pour recevoir les signaux HIGH et LOW. Il produit le signal DETVER sur une sortie 118. Le signal DETVER est dans un premier état si la boucle est verrouillée et dans un deuxième état sinon. Ici, on considère que le premier état est l'état bas et que le deuxième état est l'état haut.

Un inverseur 120 reçoit le signal LOW sur une entrée et produit sur une sortie un signal logique /LOW, inverse du signal LOW. Une porte logique 122 de type NON_OU à deux entrées reçoit les signaux HIGH et /LOW en entrée. Elle produit sur une sortie un signal logique G7 qui est intégré par un filtre de type RC composé d'une résistance 126 et d'une capacité 124 montées en série entre la sortie de la porte 122 et une masse. La tension aux bornes de la capacité 124 est comparée à un potentiel de référence REFDET dans un comparateur 128. Le potentiel REFDET sera compris entre les potentiels d'alimentation et de référence. Celui-ci produit un signal logique G8. Le signal G8 est dans un premier état quand la tension aux bornes de la capacité est supérieure au potentiel REFDET et il est dans un deuxième état sinon. Un inverseur 119 reçoit le signal G8 sur une entrée et produit le signal DETVER sur une sortie.

Si la boucle est verrouillée, on produit des impulsions très courtes dans les signaux LOW et HIGH au moment des fronts dans les signaux SREF et SIN. Ces impulsions ont par exemple une durée de l'ordre de la centaine de nanosecondes. Compte tenu des polarités considérées pour les signaux HIGH et LOW, ces impulsions correspondent à des états hauts dans les signaux HIGH et /LOW.

Supposons que la boucle est verrouillée et que les signaux HIGH et /LOW sont à l'état bas. La capacité 124 est chargée. Le signal G8 est alors à l'état haut et le signal DETVER est à l'état bas. Si un front apparaît dans le signal SIN ou dans le signal SREF, une impulsion positive apparaît sur l'une des entrées de la porte 122. Par conséquent, la capacité commence à se décharger. Si la durée de l'impulsion correspond au fait que la boucle est verrouillée, elle sera courte. La chute de tension aux bornes de la capacité sera donc faible. Il suffit de choisir la valeur du potentiel REFDET de sorte que la tension aux bornes de la capacité lui soit supérieure quand la boucle est verrouillée, pour que le signal DETVER reste inchangé dans cette hypothèse. Si la boucle n'est pas verrouillée, on produit des impulsions de durée plus importante. On décharge alors la capacité, de telle sorte que le signal DETVER change d'état.

La figure 11 illustre le circuit de fenêtrage 840 du circuit 820 de la figure 9. Le circuit 860 sera analogue au circuit 840.

Le circuit 840 comprend les mêmes éléments que le circuit 84 décrit en référence à la figure 8, à l'exception de l'inverseur 106. Il comprend, en sus, une entrée 130 pour recevoir le signal DETVER. L'inverseur 106 est remplacé par une porte logique 132 de type NON_OU à deux entrées. Cette porte reçoit les signaux DETVER et VS sur ses entrées et produit, sur une sortie, un signal logique G9. La porte 108 reçoit les signaux /HIGH et G9 sur ses entrées.

Par rapport au circuit 84 décrit précédemment, le circuit 840 ne limite la durée de la charge ou de la décharge du filtre capacitif que lorsque la boucle est verrouillée. Cela permet d'avoir un temps de réponse rapide de la boucle aux variations limitées de déphasage entre les signaux SIN et SREF. On évite donc le phénomène de gigue dans la boucle. Par contre, quand la boucle n'est pas verrouillée et qu'elle cherche à se caler sur le signal d'entrée, on ne limite pas la durée de la charge ou de la décharge mais le courant de charge ou de décharge dans la pompe. La figure 12 illustre une pompe 60 modifiée en ce sens.

La pompe 60 de la figure 12 comporte, outre les éléments décrits en référence à la figure 3, une entrée 134 pour recevoir le signal DETVER, un interrupteur 136 et une résistance 138.

La résistance 138 est montée en série avec la résistance 70 entre les transistors 58 et 64. L'interrupteur 136 est monté en parallèle avec la résistance 138. L'interrupteur est commandé par le signal DETVER de telle sorte qu'il est fermé (c'est-à-dire passant) quand le signal DETVER est à l'état bas et qu'il est ouvert (c'est-à-dire bloqué) quand le signal DETVER est à l'état haut. Ainsi, quand la boucle est verrouillée, on court-circuite la résistance 138 et la pompe 60 a des caractéristiques analogues à la pompe 6. Quand la boucle n'est pas verrouillée, la résistance 138 s'ajoute à la résistance 70 et on diminue le courant de charge et de décharge.

Les figures 13a à 13c illustrent le comportement d'une boucle selon l'état de la technique et selon l'invention face à une disparition des impulsions dans un signal de synchronisation reçu HSYNC (illustré sur le figure 13a). On suppose que la boucle recevant le signal HSYNC est verrouillée antérieurement à cette disparition La figure 13c illustre le signal DETVER.

La figure 13b représentent trois tensions produites par le filtre d'une boucle selon que l'on considère la boucle selon l'état de la technique (courbe VREF1), une boucle comprenant les circuits de fenêtrage mais sans tenir compte du verrouillage de la pompe (courbe VREF2) et une boucle mettant en oeuvre l'invention en tenant compte du verrouillage de la pompe (courbe VREF3) Les courbes sont décalées de sorte à en faciliter la lecture

Dans le premier cas, au moment où les impulsions disparaissent (instant t1 sur la figure 13b), la tension VREF1 chute très rapidement selon une pente en 1/R.C2. Puis, la capacité la plus faible étant déchargée (capacité 76 de la figure 4), la capacité 80 se décharge avec une pente plus faible ΔV/Δt = Idch/C1.

Dans le second cas, la tension VREF2 chute rapidement, avec la même pente 1/R.C2 que dans le cas illustré sur la courbe VREF1. Cette chute s'interrompt avant que la capacité la plus faible ne soit déchargée, par l'action du dispositif de limitation de la durée de charge ou de décharge. La tension VREF2 se stabilise et ne varie plus si aucune impulsion n'apparaît dans le signal SIN.

Dans le troisième cas, la tension VREF3 suit les mêmes variations que la courbe VREF2 tant que la perte de verrouillage n'a pas été détectée. Une fois celle-ci détectée, la capacité 76 continue à se décharger avec une pente ΔV/Δt = l'dch/C1 plus faible, avec I'dch = (VCC - Vbe)/(R1 + R2) < Idch, R2 étant la valeur de la résistance 138. Puis la capacité 80 se décharge également, avec une pente de décharge plus faible que dans le cas de la courbe VREF1. Si aucune impulsion n'apparaît dans le signal HSYNC, on va décharger complètement le filtre comme c'est le cas pour la boucle selon l'état de la technique. Par rapport au cas illustré par la courbe VREF2, on aura l'avantage de connaître, une fois la décharge accomplie, la tension produite par le filtre et, plus généralement, l'état de la boucle. Cela peut être intéressant, par exemple pour effectuer des tests en sortie de chaîne de production des moniteurs. D'autre part, une tension VREF faible correspond à une fréquence moins élevée de balayage horizontal. La limitation de cette tension permet de limiter le stress des composants pilotés par la boucle.

Ainsi, les circuits selon l'invention permettent d'obtenir une adaptation rapide de la pompe aux faibles variations du signal d'entrée (ce qui permet d'avoir une bonne stabilité de la pompe), tout en limitant des variations importantes rapides de la fréquence du signal produit en sortie de la boucle. Bien entendu, l'invention ne saurait se limiter aux exemples particuliers décrits. Ainsi, on pourra par exemple modifier les polarités des signaux produits ou modifier les portes qui les produisent, sans sortir du cadre de l'invention.

## Revendications

1. Boucle à verrouillage de phase comprenant un comparateur (4), une pompe de charge (6, 60), un filtre capacitif (8), un oscillateur contrôlé en tension (10) et un dispositif d'ajustement de phase (12), le comparateur comparant les phases d'un signal impulsionnel d'entrée (SIN) et d'un signal impulsionnel de référence (SREF) fourni par le dispositif d'ajustement de phase (12) et produisant des signaux de commande (HIGH, LOW) de charge et de décharge, la pompe de charge (6) étant apte à charger ou décharger le filtre capacitif (8) en fonction des signaux de commande de charge et de décharge, le filtre étant chargé ou déchargé quand ces signaux sont dans un premier état et isolé de la pompe de charge quand ils sont dans un deuxième état, la boucle comprenant un dispositif (82, 820) de limitation du courant de charge et de décharge du filtre capacitif, ce dispositif comprenant des circuits de fenêtrage (84, 86, 840, 860) pour limiter la durée pendant laquelle les signaux de commande de charge et de décharge (HIGH, LOW) sont dans leur premier état, caractérisée en ce que le dispositif (820) de limitation comprend un circuit (110) de détection de verrouillage de la boucle et en ce que la pompe de charge (60) comprend des moyens (134, 136, 138) pour limiter la valeur du courant de charge ou de décharge du filtre, le circuit de détection de verrouillage produisant un signal de détection de verrouillage (DETVER) représentatif du fait que la boucle est ou n'est pas verrouillée, le signal de détection étant fourni aux circuits de fenêtrage (840, 860) et à la pompe de charge (60) de manière à limiter la durée pendant laquelle les signaux de commande de charge et de décharge sont dans leur premier état quand la boucle est verrouillée, et à limiter la valeur du courant de charge ou de décharge quand la boucle n'est pas verrouillée.

2. Boucle selon la revendication 1, caractérisée en ce que les circuits de fenêtrage (84, 86, 840, 860) produisent, à partir des signaux de commande (HIGH, LOW) de charge et de décharge, des signaux de commande de charge et de décharge (HIGH2, LOW2, HIGH3, LOW3) dérivés dont les états reproduisent les états de des signaux de commande, les signaux de commande dérivés pilotant la pompe de charge, et les circuits de fenêtrage comprenant des moyens de limitation (100, 102, 104, 108) pour imposer une modification de l'état de ces signaux de commande dérivés de telle sorte que le filtre est isolé de la pompe quand il a été chargé ou déchargé durant un délai défini par ces moyens de limitation.

3. Boucle selon la revendication 2, caractérisée en ce que les circuits de fenêtrage (840, 860) reçoivent le signal de détection de verrouillage, et en ce que les moyens de limitation sont inopérants quand ce signal est représentatif du fait que la boucle n'est pas verrouillée.

4. Boucle selon l'une des revendications 1 à 3, caractérisée en ce que la pompe de charge (60) reçoit le signal de détection de verrouillage et comprend des résistances (70, 138) montées en série et permettant de contrôler la valeur du courant de charge ou de décharge, le signal de détection pilotant des moyens de commutation (136) aptes à court-circuiter ou à relier aux autres résistances au moins l'une des résistances (138) de sorte à augmenter ou diminuer le courant de charge ou de décharge.

## Claims

1. A phase-locked loop including a comparator (4), a charge pump (6, 60), a capacitive filter (8), a voltage-controlled oscillator (10) and a phase adjustment device (12), the comparator comparing the phases of an input pulse signal (SIN) and of a reference pulse signal (SREF) supplied by the phase adjustment device (12), and generating charge and discharge control signals (HIGH, LOW), the charge pump (6) being fit for charging or discharging the capacitive filter (8) according to the charge and discharge control signals, the filter being charged or discharged when these signals are in a first state and insulated from the charge pump when they are in a second state, the loop including a device (82, 820) for limiting the charge and discharge current of the capacitive filter, this device including windowing circuits (84, 86, 840, 860) for limiting the time during which the charge and discharge control signals (HIGH, LOW) are in their first state, characterized in that the limiting device (820) includes a circuit (110) for detecting the locking of the loop and wherein the charge pump (60) includes means (134, 136, 138) for limiting the value of the charge or discharge current of the filter, the circuit for detecting the locking generating a locking detection signal (DETVER) representative of the fact that the loop is or is not locked, the detection signal being supplied to the windowing circuits (840, 860) and to the charge pump (60), to limit the time during which the charge and discharge control signals are in their first state when the loop is locked, and to limit the value of the charge or discharge current when the loop is not locked.

2. A loop according to claim 1, wherein the windowing circuits (84, 86, 840, 860) generate, based on the charge and discharge control signals (HIGH, LOW), derived charge and discharge control signals (HIGH2, LOW2, HIGH3, LOW3), the states of which reproduce the states of the control signals, the derived control signals driving the charge pump, and the windowing circuits including limiting means (100, 102, 104, 108) for imposing a modification of the state of these derived control signals so that the filter is insulated from the pump when it has been charged or discharged during a delay defined by these limiting means.

3. A loop according to claim 2, wherein the windowing circuits (840, 860) receive the locking detection signal, and wherein the limiting means are inoperative when this signal is representative of the fact that the loop is not locked.

4. A loop according to any of claims 1 to 3, wherein the charge pump (60) receives the locking detection signal and includes resistors (70, 138) mounted in series and enabling to control the value of the charge or discharge current, the detection signal driving switching means (136) for short-circuiting or connecting to the other resistors at least one of the resistors (138) so as to increase or decrease the charge or discharge current.

## Patentansprüche

1. PLL(phase locked loop)-Phasenregelkreis mit Phasenverriegelung, umfassend einen Komparator (4), eine Ladungspumpe (6, 60), ein kapazitives Filter (8), einen spannungsgesteuerten Oszillator (10) und eine Phaseneinstellvorrichtung (12), wobei der Komparator die Phasen eines Eingangs-Impulssignals (SIN) und eines von der Phaseneinstellvorrichtung (12) gebildeten Bezugs-Impulssignals (SREF) vergleicht und Steuersignale (HIGH, LOW) zum Laden und Entladen erzeugt, die Ladungspumpe (6) zum Laden oder Entladen des kapazitiven Filters (8) in Abhängigkeit von den Lade- und Entlade-Steuersignalen dient, das Filter geladen oder entladen wird, wenn diese Signale sich in einem ersten Zustand befinden, und von der Ladungspumpe getrennt ist, wenn sie sich in einem zweiten Zustand befinden, und wobei der Regelkreis bzw. die Regelschleife eine Vorrichtung (82, 820) zur Begrenzung des Lade- und Entladestroms des kapazitiven Filters enthält, wobei diese Vorrichtung Fensterbildungsschaltungen (84, 86, 840, 860) zur Begrenzung der Dauer, während der die Lade- und Entlade-Steuersignale (HIGH, LOW) sich in ihrem ersten Zustand befinden, aufweist, dadurch gekennzeichnet, daß die Begrenzungsvorrichtung (820) eine Schaltung (110) zum Nachweis bzw. zur Detektion der Verriegelung des Regelkreises umfaßt und daß die Ladungspumpe (60) Mittel (134, 136, 138) zur Begrenzung des Betrags des Lade- oder Entladestroms des Filters aufweist und die Schaltung zum Nachweis bzw. zur Detektion der Verriegelung ein Verriegelungsnachweissignal (DETVER) erzeugt, das wiedergibt, ob der Regelkreis bzw. die Regelschleife verriegelt ist oder nicht, daß das Nachweissignal den Fensterbildungsschaltungen (840, 860) und der Ladungspumpe (60) zugeführt wird, um die Dauer, während welcher die Lade- und Entlade-Steuersignale sich in ihrem ersten Zustand befinden, zu begrenzen, wenn der Regelkreis bzw. die Regelschleife verriegelt ist, und um den Betrag des Lade- oder Entladestroms zu begrenzen, wenn der Regelkreis bzw. die Regelschleife nicht verriegelt ist.

2. Phasenregelkreis bzw. -schleife nach Anspruch 1, dadurch gekennzeichnet, daß die Fensterschaltungen (84, 86, 840, 860) auf der Grundlage der Lade- und Entlade-Steuersignale (HIGH, LOW) abgeleitete Lade- und Entlade-Steuersignale (HIGH2, LOW2, HIGH3, LOW3) bilden, deren Zustände die Zustände der Steuersignale reproduzieren, wobei die abgeleiteten Steuersignale die Ladungspumpe steuern, und daß die Fensterschaltungen Begrenzungsmittel (100, 102, 104, 108) aufweisen, welche eine Zustandsänderung dieser abgeleiteten Steuersignale bewirken, derart daß das Filter von der Pumpe getrennt wird, nachdem es während einer durch diese Begrenzungsmittel definierten Verzögerungszeit geladen oder entladen wurde.

3. Phasenregelkreis bzw. -schleife nach Anspruch 2, dadurch gekennzeichnet, daß den Fensterschaltungen (840, 860) das Verriegelungs-Nachweis- bzw. -Detektionssignal zugeführt wird und daß die Begrenzungsmittel unwirksam sind, wenn das Signal den Zustand anzeigt, daß der Regelkreis bzw. die Regelschleife nicht verriegelt ist.

4. Phasenregelkreis bzw. -schleife nach einem der Ansprüche 1 bis 3,
dadurch gekennzeichnet, daß die Ladungspumpe (60) das Verriegelungs-Nachweis- bzw. -Detektionssignal zugeführt erhält und in Reihe angeordnete Widerstände (70, 138) aufweist, welche eine Steuerung des Betrags des Lade- oder Entladestroms gestatten, und daß das Nachweis- bzw. Detektionssignal Umschaltmittel (136) steuert, mittels welchen wenigstens einer der Widerstände (138) kurzgeschlossen oder mit den anderen Widerständen verbunden werden kann, um den Lade- oder Entladestrom zu erhöhen oder zu verringern.
